# EUROPEAN PATENT APPLICATION

(11) **EP 4 565 017 A1**
(43) Date of publication of application: **04.06.2025**
(21) Application number: 24215820.2
(22) Date of filing: 27.11.2024
(51) Int. Cl.: H05K 3/40, H05K 1/18, H05K 3/34

(54) **A PRINTED CIRCUIT BOARD**

(30) Priority: 28.11.2023 IN 202321080585
(71) Applicant: Vertiv Corporation, Westerville, OH 43082 (US)
(72) Inventor: BOROLE, RAJAN SURESH, Westerville, 43082 (US); SUMBE, RAVIRAJ PRAKASH, Westerville, 43082 (US)
(74) Representative: Beal, James Michael

(57) **Abstract**

A printed circuit board includes a first surface opposite a second surface. The printed circuit board also includes at least one daughter circuit board component mounted on a first side edge of a plurality of side edges defined by the first surface and the second surface. The printed circuit board also includes at least one surface mount device component mounted to one of the first side edge or another side edge of the plurality of side edges.

## Description

### CROSS REFERENCE TO RELATED APPLICATIONS

This Application claims the benefit of Indian Provisional Patent Application Serial No. 202321080585 titled "A Printed Circuit Board" filed November 28, 2023.

### FIELD

The present invention relates to the field of printed circuit boards.

### BACKGROUND

A printed circuit board is an important component when it comes to electronic devices. The printed circuit board, commonly known as PCB, consists of at least one pair of daughter circuit boards, SMD components and other components, all mounted on a top surface and bottom surface of the PCB of the PCB.

Over the time, a need for reduction in size of the PCB has been identified so that space on the PCB is effectively achieved and cost and time of manufacturing is conversely reduced. However, reduction in size adversely affects the power density of the PCB. Further, arranging all the components of the PCB thereon, with an aim to reduce the size of the PCB, decreases its reliability during EMC/EMI testing.

### BRIEF DESCRIPTION OF THE ACCOMPANYING DRAWING

An aspect of the disclosed embodiments includes an apparatus. The apparatus includes a printed circuit board (PCB). The PCB includes: a first surface opposite a second surface; at least one daughter circuit board component mounted on a first side edge of a plurality of side edges defined by the first surface and the second surface; and at least one surface mount device (SMD) component mounted to one of the first side edge or another side edge of the plurality of side edges.

### BRIEF DESCRIPTION OF THE ACCOMPANYING DRAWING

A printed circuit board of the present disclosure will now be described with the help of the accompanying drawing, in which:
FIG. 1 illustrates an isometric view of a conventional printed circuit board;
FIG. 2 illustrates an isometric view of the printed circuit board, in accordance the principles of the present disclosure;
FIG. 3 illustrates an isometric view of the printed circuit board, of FIG. 1, having an SMD component mounted thereon;
FIGS. 4A and 4B illustrates an isometric view of the printed circuit board, of FIG. 1, with SMD spring components mounted thereon; and
FIG. 5 illustrates an isometric view of springs that can be mounted on the PCB of FIG. 1.

### DETAILED DESCRIPTION

Embodiments, of the present disclosure, will now be described with reference to the accompanying drawing.

Embodiments are provided so as to thoroughly and fully convey the scope of the present disclosure to the person skilled in the art. Numerous details are set forth, relating to specific components, and methods, to provide a complete understanding of embodiments of the present disclosure. It will be apparent to the person skilled in the art that the details provided in the embodiments should not be construed to limit the scope of the present disclosure. In some embodiments, well-known processes, well-known apparatus structures, and well-known techniques are not described in detail.

The terminology used, in the present disclosure, is only for the purpose of explaining a particular embodiment and such terminology shall not be considered to limit the scope of the present disclosure. As used in the present disclosure, the forms "a", "an" and "the" may be intended to include the plural forms as well, unless the context clearly suggests otherwise. The terms "comprises", "comprising", "including", "includes" and "having" are open-ended transitional phrases and therefore specify the presence of stated features, elements, modules, units and/or components, but do not forbid the presence or addition of one or more other features, elements, components, and/or groups thereof.

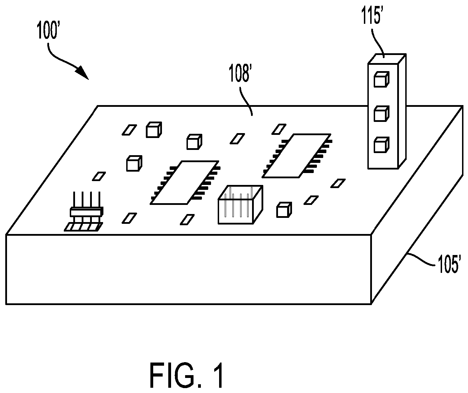

A conventional printed circuit board (100') is illustrated in FIG. 1, having a daughter circuit board (115') mounted on a top surface (108') and bottom surface (105') of the conventional printed circuit board (100').

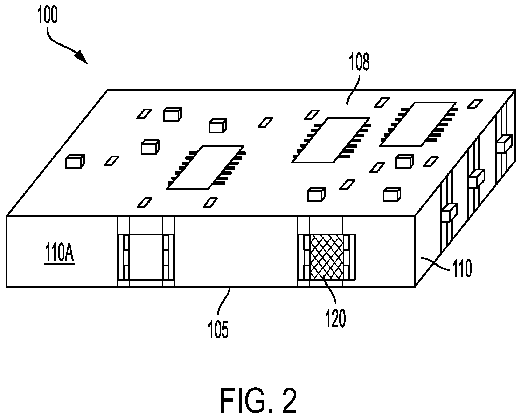

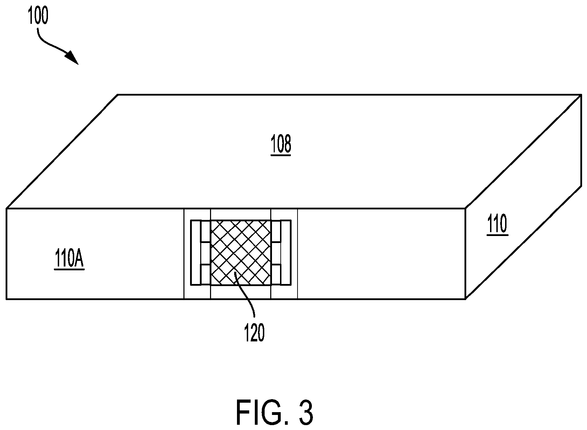

A printed circuit board will now be described in detail with reference to FIG. 2 through FIG. 5. The printed circuit board (herein referred to as 'the main PCB (100)') includes a bottom surface (105), a top surface (108), and side edges (110) defined between the bottom surface (105) and the top surface (108), as shown in FIG. 2.

In some embodiments, the main PCB (100) includes daughter circuit board components (115) configured to be mounted on a first side edge (110A) of the side edges (110).

In some embodiments, the main PCB (100) further includes a plurality of surface mount device (SMD) components configured to be mounted on a side edge (110A) of the main PCB (100). In some embodiments, the SMD components (120) are mounted on the main PCB (100) by grooving or plating the main PCB (100). In some embodiments, the mounting of the SMD components (120) on the main PCB (100) is facilitated by gold plating or tin plating.

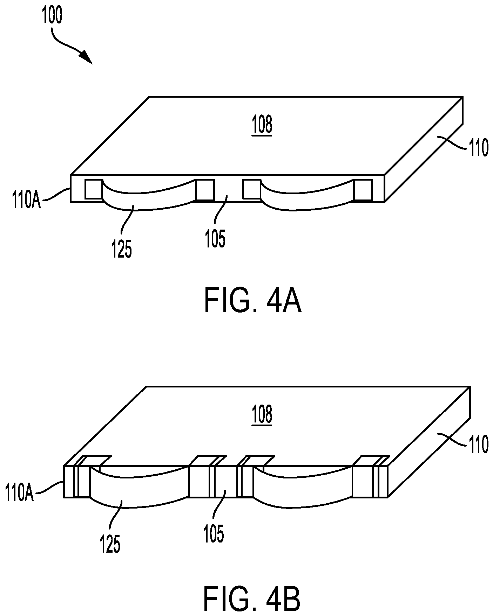

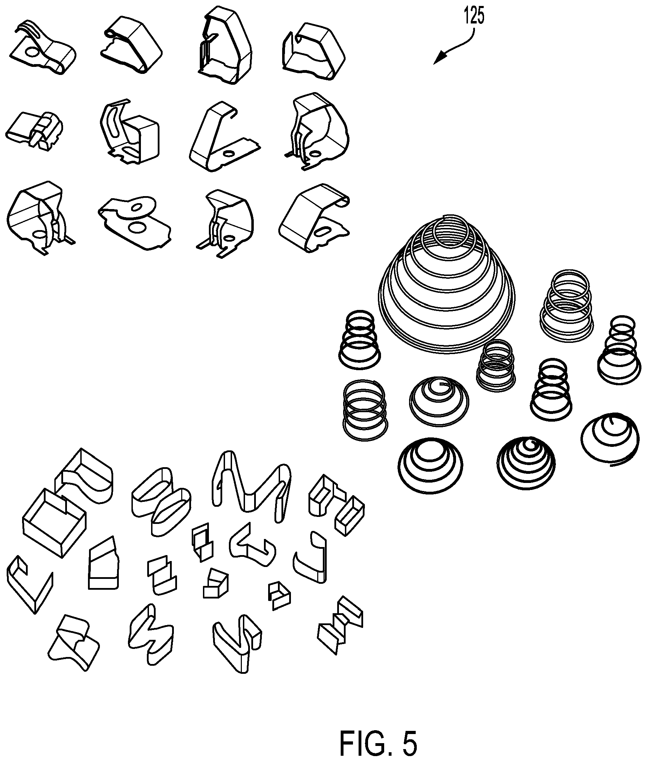

FIG. 4A and FIG. 4B illustrates mounting of electromechanical components on the side edge (110) of the main PCB (100). For example, the springs (125) of the SMD components (120) are mounted on the side edge (110) as power contacts. Due to the flexibility of the springs (125), the tolerances between the two contacting surfaces are taken care of. In a similar way, other electromechanical components (as shown in FIG. 5) are mounted on the side edge (110) of the main PCB (100) to ensure mechanical strength, flexibility, suspension, power connections and other advantages.

In some embodiments, the daughter circuit board is eliminated since the daughter circuit board components (115) can now be mounted on the side edges (110), while other SMD components (120) can be mounted on the first side edge (110A) of the main PCB (100), thereby freeing up area on the main PCB (100) to facilitate mounting of other components of the main PCB (100) in the available area. This is particularly advantageous for facilitating reduction in the surface area of the main PCB (100), because the other components can be fitted on the available free space on the top surface (108) of the main PCB (100).

Thus, not only can the size of the PCB (100) be reduced, but also the time and cost required for manufacturing and assembling the main PCB (100) can be saved. Further, since the daughter circuit board components (115) are now fitted on the side edge (110A), the reliability of the PCB (100) increases during electromagnetic interference (EMI) / electromagnetic compatibility (EMC) testing. Additionally, the daughter circuit board components (115) can be eliminated if desired, thereby eliminating the cost of the daughter circuit board.

In some embodiments, a conventional PCB (100') has a surface area of 3960 square mm of which 211 square mm surface area was utilized for mounting components thereon. The PCB (100') includes a pair of daughter circuit boards (115') that consumed around 363 square mm of area of the top surface (108') of the PCB (100').

The position of the daughter board components (115) was changed to a side edge (110) of the PCB (100), thereby utilizing 543 square mm area of the side edge. This contributed in saving around 14% of the PCB area. Further, SMD components (120) such as resistors, capacitors, diodes, light emitting diodes (LEDs), integrated circuits (ICs) of width less than 1.56mm can be fitted on a PCB (100) of standard thickness of 1.56mm.

In some embodiments, the systems and methods described herein may be configured to provide a printed circuit board having relatively reduced surface area without compromising on the efficiency thereof, and that is cost-effective and reduces manufacturing and assembly time and/or resources.

In some embodiments, the systems and methods described herein may be configured to provide a printed circuit board. In some embodiments, the systems and methods described herein may be configured to provide a printed circuit board having relatively reduced surface area without compromising on the efficiency thereof. In some embodiments, the systems and methods described herein may be configured to provide a printed circuit board which is cost-effective and consumes relatively less time for its manufacturing and assembly.

In some embodiments, an apparatus includes a printed circuit board (PCB). The PCB includes: a first surface opposite a second surface; at least one daughter circuit board component mounted on a first side edge of a plurality of side edges defined by the first surface and the second surface; and at least one surface mount device (SMD) component mounted to one of the first side edge or another side edge of the plurality of side edges.

In some embodiments, the at least one SMD component is mounted to the one of the first side edge or the other side edge of the plurality of side edges by grooving the one of the first side edge or the other side edge of the plurality of side edges. In some embodiments, the at least one SMD component is mounted to the one of the first side edge or the other side edge of the plurality of side edges by plating the one of the first side edge or the other side edge of the plurality of side edges. In some embodiments, plating the one of the first side edge or the other side edge of the plurality of side edges includes using a gold plating material. In some embodiments, plating the one of the first side edge or the other side edge of the plurality of side edges includes using a tin plating material. In some embodiments, the at least one SMD component includes at least one power contact. In some embodiments, the at least one power contact comprises at least one spring mounted on the one of the first side edge or another side edge of the plurality of side edges.

In some embodiments, the PCB further includes at least one electromechanical component mounted on the one of the first side edge or another side edge of the plurality of side edges. In some embodiments, the at least one electromechanical component includes at least one power contact. In some embodiments, each side edge the plurality of sides is disposed between the first surface and the second surface. In some embodiments, the first surface includes a first surface area.

In some embodiments, the first surface area is less than 3960 square millimeters. In some embodiments, the second surface includes a second surface area. In some embodiments, the second surface area is less than 3960 square millimeters. In some embodiments, the PCB comprises a thickness of 1.56 millimeters. In some embodiments, the at least one daughter circuit board component utilizes a portion of a side edge area associated with each side edge of the plurality of side edges.

In some embodiments, the portion of the side edge area is 543 square millimeters. In some embodiments, the at least one SMD component includes at least one of a resistor, a capacitor, a diode, a light emitting diode, and an integrated circuit. In some embodiments, the integrated circuit has width that is equal to or less than 1.56 millimeters. In some embodiments, the PCB includes at least one component mounted on at least one of the first surface and the second surface.

The foregoing description of the embodiments has been provided for purposes of illustration and not intended to limit the scope of the present disclosure. A person of ordinary skill in the art would understand that certain modifications could come within the scope of this disclosure. Such variations are not to be regarded as a departure from the present disclosure, and all such modifications are considered to be within the scope of the present disclosure.

The foregoing disclosure has been described with reference to the accompanying embodiments which do not limit the scope and ambit of the disclosure. The description provided is purely by way of example and illustration.

The embodiments herein and the various features and advantageous details thereof are explained with reference to the non-limiting embodiments in the following description. Descriptions of well-known components and processing techniques are omitted so as to not unnecessarily obscure the embodiments herein. The examples used herein are intended merely to facilitate an understanding of ways in which the embodiments herein may be practiced and to further enable those of skill in the art to practice the embodiments herein. Accordingly, the examples should not be construed as limiting the scope of the embodiments herein.

The foregoing description of the specific embodiments so fully reveal the general nature of the embodiments herein that others can, by applying current knowledge, readily modify and/or adapt for various applications such specific embodiments without departing from the generic concept, and, therefore, such adaptations and modifications should and are intended to be comprehended within the meaning and range of equivalents of the disclosed embodiments. It is to be understood that the phraseology or terminology employed herein is for the purpose of description and not of limitation. Therefore, while the embodiments herein have been described herein, those skilled in the art will recognize that the embodiments herein can be practiced with modification within the spirit and scope of the embodiments as described herein.

Any discussion of materials, devices, articles or the like that has been included in this specification is solely for the purpose of providing a context for the disclosure. It is not to be taken as an admission that any or all of these matters form a part of the prior art base or were common general knowledge in the field relevant to the disclosure as it existed anywhere before the priority date of this application.

The numerical values mentioned for the various physical parameters, dimensions or quantities are only approximations and it is envisaged that the values higher/lower than the numerical values assigned to the parameters, dimensions or quantities fall within the scope of the disclosure, unless there is a statement in the specification specific to the contrary.

While considerable emphasis has been placed herein on the components and component parts of the described embodiments, it will be appreciated that many embodiments can be made and that many changes can be made in the described embodiments without departing from the principles of the disclosure. These and other changes in the embodiments of the disclosure will be apparent to those skilled in the art from the disclosure herein, whereby it is to be distinctly understood that the foregoing descriptive matter is to be interpreted merely as illustrative of the disclosure and not as a limitation.

The disclosure comprises the following items:
1. An apparatus comprising:
   a printed circuit board (PCB) that includes:
   a first surface opposite a second surface;
   at least one daughter circuit board component mounted on a first side edge of a plurality of side edges defined by the first surface and the second surface; and
   at least one surface mount device (SMD) component mounted to one of the first side edge or another side edge of the plurality of side edges.
2. The apparatus of item 1, wherein the at least one SMD component is mounted to the one of the first side edge or the other side edge of the plurality of side edges by grooving the one of the first side edge or the other side edge of the plurality of side edges.
3. The apparatus of item 1 or item 2, wherein the at least one SMD component is mounted to the one of the first side edge or the other side edge of the plurality of side edges by plating the one of the first side edge or the other side edge of the plurality of side edges.
4. The apparatus of any preceding item, wherein plating the one of the first side edge or the other side edge of the plurality of side edges includes using a gold plating material.
5. The apparatus of any preceding item, wherein plating the one of the first side edge or the other side edge of the plurality of side edges includes using a tin plating material.
6. The apparatus of any preceding item, wherein the at least one SMD component includes at least one power contact.
7. The apparatus of any preceding item, wherein the at least one power contact comprises at least one spring mounted on the one of the first side edge or another side edge of the plurality of side edges.
8. The apparatus of any preceding item, wherein the PCB further includes at least one electromechanical component mounted on the one of the first side edge or another side edge of the plurality of side edges.
9. The apparatus of any preceding item, wherein the at least one electromechanical component includes at least one power contact.
10. The apparatus of any preceding item, wherein each side edge the plurality of side edges is disposed between the first surface and the second surface.
11. The apparatus of any preceding item, wherein the first surface includes a first surface area.
12. The apparatus of any preceding item, wherein the first surface area is less than 3960 square millimeters.
13. The apparatus of any preceding item, wherein the second surface includes a second surface area.
14. The apparatus of any preceding item, wherein the second surface area is less than 3960 square millimeters.
15. The apparatus of any preceding item, wherein the PCB comprises a thickness of 1.56 millimeters.
16. The apparatus of any preceding item, wherein the at least one daughter circuit board component utilizes a portion of a side edge area associated with each side edge of the plurality of side edges.
17. The apparatus of any preceding item, wherein the portion of the side edge area is 543 square millimeters.
18. The apparatus of any preceding item, wherein the at least one SMD component includes at least one of a resistor, a capacitor, a diode, a light emitting diode, and an integrated circuit.
19. The apparatus of any preceding item, wherein the integrated circuit has width that is equal to or less than 1.56 millimeters.
20. The apparatus of any preceding item, wherein the PCB includes at least one component mounted on at least one of the first surface and the second surface.

## Claims

1. An apparatus comprising:
a printed circuit board, PCB, that includes:
a first surface opposite a second surface;
at least one daughter circuit board component mounted on a first side edge of a plurality of side edges defined by the first surface and the second surface; and
at least one surface mount device, SMD, component mounted to one of the first side edge or another side edge of the plurality of side edges.

2. The apparatus of claim 1, wherein the at least one SMD component is mounted to the one of the first side edge or the other side edge of the plurality of side edges by grooving the one of the first side edge or the other side edge of the plurality of side edges.

3. The apparatus of claim 1, wherein the at least one SMD component is mounted to the one of the first side edge or the other side edge of the plurality of side edges by plating the one of the first side edge or the other side edge of the plurality of side edges.

4. The apparatus of claim 3, wherein plating the one of the first side edge or the other side edge of the plurality of side edges includes using a gold plating material or a tin plating material.

5. The apparatus of any preceding claim, wherein the at least one SMD component includes at least one power contact.

6. The apparatus of claim 5, wherein the at least one power contact comprises at least one spring mounted on the one of the first side edge or another side edge of the plurality of side edges.

7. The apparatus of any of claims 1-4, wherein the PCB further includes at least one electromechanical component mounted on the one of the first side edge or another side edge of the plurality of side edges.

8. The apparatus of claim 7, wherein the at least one electromechanical component includes at least one power contact.

9. The apparatus of any preceding claim, wherein each side edge the plurality of side edges is disposed between the first surface and the second surface.

10. The apparatus of any preceding claim, wherein the first surface includes a first surface area, wherein the first surface area is less than 3960 square millimeters.

11. The apparatus of any preceding claim, wherein the second surface includes a second surface area, wherein the second surface area is less than 3960 square millimeters.

12. The apparatus of any preceding claim, wherein the PCB comprises a thickness of 1.56 millimeters.

13. The apparatus of any preceding claim, wherein the at least one daughter circuit board component utilizes a portion of a side edge area associated with each side edge of the plurality of side edges, and optionally wherein the portion of the side edge area is 543 square millimeters.

14. The apparatus of any preceding claim, wherein the at least one SMD component includes at least one of a resistor, a capacitor, a diode, a light emitting diode, and an integrated circuit, and/or wherein the integrated circuit has width that is equal to or less than 1.56 millimeters.

15. The apparatus of any preceding claim, wherein the PCB includes at least one component mounted on at least one of the first surface and the second surface.
